Europäisches Patentamt

European Patent Office

Office européen des brevets

(11) Publication number : **0 514 103 A1**

## (12) EUROPEAN PATENT APPLICATION

(21) Application number : **92304216.2**

(22) Date of filing : **11.05.92**

(51) Int. Cl.⁵ : **H01L 21/285**

(30) Priority : **14.05.91 US 699741**

(43) Date of publication of application :
**19.11.92 Bulletin 92/47**

(84) Designated Contracting States :
**DE FR GB IT**

(71) Applicant : **SGS-THOMSON
MICROELECTRONICS, INC. (a Delaware
corp.)
1310 Electronics Drive
Carrollton, TX 75006 (US)**

(72) Inventor : **Chen, Fusen
18175 Midway No.299
Dallas, Texas 75287 (US)**
Inventor : **Liou, Fu-Tai
2027 Lansdown Drive
Carrollton, Texas 75018 (US)**

(74) Representative : **Palmer, Roger et al
PAGE, WHITE & FARRER 54 Doughty Street
London WC1N 2LS (GB)**

(54) Barrier metal process for sub-micron contacts.

(57) An insulating layer (24) is formed over the integrated circuit. A photoresist layer (26) is formed over the integrated circuit, patterned and developed. The insulating layer (24) is etched to form a contact opening (27) and to expose a selected region (22) of the conductive structure. The photoresist layer (26) is removed, after which a first refractory metal layer (28) is formed over the insulating layer (24) and in the contact opening (27) covering the exposed selected region (22) of the conductive structure. A refractory metal nitride layer (30) is then formed over the first refractory metal layer (28). Optionally, a second refractory metal layer (32) is formed over the refractory metal nitride layer (30). The first refractory metal layer (28), the refractory metal nitride layer (30), and the second refractory metal layer (32), if formed, are annealed.

FIG. 2

The present invention relates generally to semiconductor integrated circuit processing, and more specifically to forming a barrier for sub-micron contacts in integrated circuits.

Aluminum metallization layers in semiconductor integrated circuits have historically been satisfactory to form contacts within an interconnection system. Barrier layers were not required between the aluminum and the underlying active device. The interdiffusion of silicon and aluminum at the junction of the active device was not significant enough to cause leakage currents because the junction depth was relatively deep.

With the trend to continue to miniaturize semiconductor integrated circuits to achieve submicron feature sizes, however, barrier metal layers have become indispensable. In the submicron regime, interdiffusion of silicon and aluminum may result in unacceptable spiking conditions and leakage currents. In order to realize high reliability, barrier metal layers may need to be formed at the junction to prevent interdiffusion between silicon and aluminum as well as stress induced voiding in sub-micron metal lines. Barrier metal layers may avoid aluminum spiking through shallow junctions into underlying, silicon substrate. Barrier layers must also maintain a good ohmic contact or low resistance contact with the active device.

Additionally, contact holes etched through the various surface layers down to the active regions of the devices must be in close proximity to other devices to allow greater packing density on the surface of the wafer. Contact openings having vertical sidewalls allow for greater packing density. Step coverage over vertical sidewalls, however, becomes a limitation with certain barrier materials. If the barrier layer is not thick enough pin holes may result, allowing spiking to occur.

In order to provide a barrier metal layer which prevents interdiffusion between the metallization layer and the underlying active device while maintaining adequate step coverage, a multilayer barrier followed by an annealing step is proposed by this invention. The sidewalls of the contact opening remain vertical to increase packing density and the barrier layer step coverage is enhanced through the use of thermal processing before a metallization layer is deposited.

It would be desirable to provide a method of forming a barrier layer to prevent interdiffusion between the metallization layer and the active device such as that which occurs between silicon and aluminum. It would further be desirable for such fabrication technique to provide adequate step coverage of the barrier layer in the bottom of the contact to prevent pin holes.

Therefore, according to the present invention, after forming a conductive structure on an integrated circuit, an insulating layer is formed over the integrated circuit. The insulating layer is then etched to form a contact opening and to expose a selected region of the conductive structure. A first refractory metal layer is formed over the insulating layer and in the contact opening covering the exposed selected portion of the conductive structure. A refractory metal nitride layer is formed over the first refractory metal layer, and optionally a second refractory metal layer is formed over the refractory metal nitride layer. The first refractory metal layer, the refractory metal nitride layer and the second refractory metal layer, if formed, are annealed in a nitrogen ambient.

The novel features believed characteristic of the invention are set forth in the appended claims. The invention itself, however, as well as a preferred mode of use, and further advantages thereof, will best be understood by reference to the following detailed description of an illustrative embodiment when read in conjunction with the accompanying drawings, wherein:

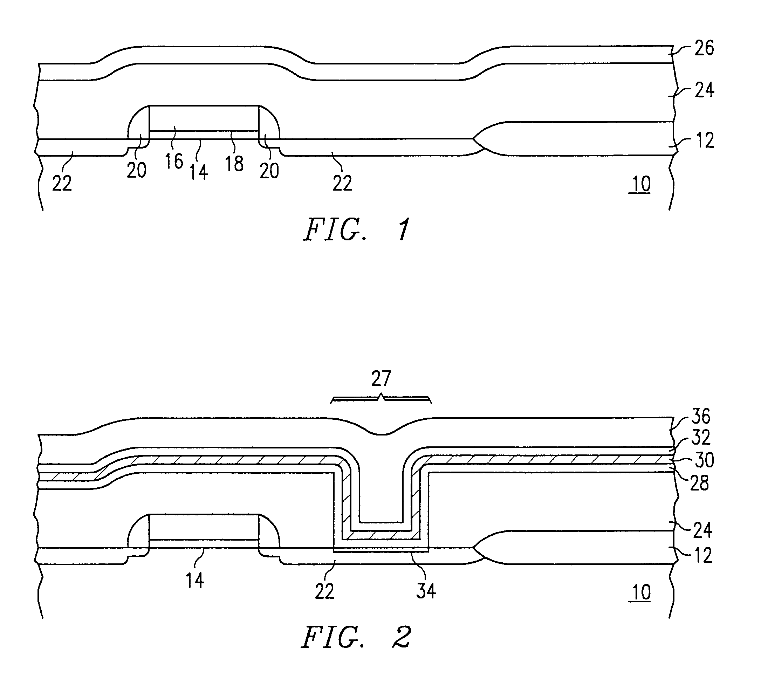

**Figures 1-2** illustrate a preferred process flow according to the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

Referring to **Figure 1**, an integrated circuit is to be formed in a substrate **10**. Selected regions of the substrate 10 are oxidized to form an oxide insulating layer **12**. A transistor **14** is formed by methods known in the art. Transistor **14** includes gate electrode **16** disposed over gate oxide **18**, oxide spacers **20** and source/drain regions **22**. Source/drain regions **22** may be N+ type or P+ type.

An insulating layer **24** is deposited over the entire surface of the chip. Preferably layer **24** is boro-phospho-silicate glass (BPSG) or phosopho-silicate glass (PSG). A thermal heat process is generally used causing the BPSG or PSG to become soft enough to flow and smooth out over the surface of the wafer. Photoresist layer 26 is then spun onto the surface of the integrated circuit, patterned and developed. Device fabrication up to this stage utilizes methods well known in the art.

Referring to **Figure 2**, the insulating layer **24** is etched using an anisotropic plasma etch to form contact opening **27** exposing a portion of source/drain region **22**. It should be noted that contacts to different active areas may be made simultaneously through insulating layer **24**. A refractory metal layer **28** such as titanium is deposited over insulating layer **24**. Metal layer **28** is deposited at a depth of between approximately 200-600 Angstroms.

A refractory metal nitride layer **30** such as titanium nitride is then deposited over metal layer **28**. Metal nitride layer **30** is deposited at a depth of between approximately 300-1000 Angstroms. Preferably another refractory metal layer **32** is deposited over the metal nitride layer **30**. This top metal layer **32** is deposited at a depth of between approximately 200-800 Angstroms.

Layers **28**, **30** and **32** may be deposited through one path of a single or multi-chamber sputtering machine. In a multi-chamber processing machine, such as the model M2000 manufactured and sold by Varian, sequential deposition of layers of different composition is provided for without requiring removal of the wafer from the deposition chamber. This process eliminates the possibility that native oxides will form on the surface of the metal layers, which would require the stripping of the native oxides immediately prior to the next deposition in order to insure good electrical continuity. An otherwise cumbersome process of depositing multiple layers of different composition in succession can be made relatively easy.

Metal layer **28**, metal nitride layer **30** and metal layer **32**, if deposited, are then annealed in a nitrogen ambient by rapid thermal annealing (RTA) or furnace reflow, heating the wafer uniformly. The RTA process occurs preferably between 650-750 degrees C. An aluminum layer **36** is then uniformly deposited across the surface of the wafer.

In the bottom of the contact opening, the titanium refractory metal layer **28** reacts with the underlying doped source/drain region **22** during the RTA process to form a titanium disilicide region **34**. This bottom layer of titanium makes a good ohmic contact with low resistance to either N+ or P+ regions. The remainder of metal layer **28** reacts with the nitrogen used during the RTA process to form titanium nitride.

The refractory metal nitride layer **30** acts as a barrier to interdiffusion between the source/drain region **22** and aluminum layer **36**. Layer **30** will also slow the titanium/silicon reaction between metal layer **28** and source/drain region **22** which forms titanium disilicide region **34**. Refractory metal layer **32** also reacts with the nitrogen used during the RTA process to form titanium nitride.

The top refractory metal layer **32**, if deposited, provides better step coverage than the refractory metal nitride layer **30**. Moreover, as both titanium metal layers **28** and **32** are partially and totally converted to titanium nitride, respectively, during the RTA process, the overall titanium nitride thickness in the bottom of the contact opening increases.

The RTA process reduces the stress between the various dissimilar metals such as the titanium and titanium nitride layers. The RTA process also converts the titanium layers to titanium nitride while the middle metal layer **32** is deposited as titanium nitride. The increased thickness of the composite titanium nitride provides a higher quality interdiffusion barrier. Titanium nitride tends to pick up oxygen or nitrogen stuffing the grain boundaries. Pin holes cannot form and aluminum spiking is prevented between the aluminum layer **36** through the source/drain region **22** and into the substrate **10**.

As will be appreciated by those skilled in the art, the process steps described above can be used with nearly any conventional process flow. While the invention has been particularly shown and described with reference to a preferred embodiment, it will be understood by those skilled in the art that various changes in form and detail may be made therein without departing from the spirit and scope of the invention.

## Claims

1. A method of forming a barrier layer in a contact of an integrated circuit comprising the steps of:

   forming a conductive structure on the integrated circuit;

   forming an insulating layer over the integrated circuit;

   etching the insulating layer to form a contact opening and exposing a selected region of the conductive structure;

   forming a first refractory metal layer over the insulating layer and in the contact opening and covering the exposed selected region of the conductive structure;

   forming a refractory metal nitride layer over the first refractory metal layer; and,

   annealing the first refractory metal layer and the refractory metal nitride layer wherein the first refractory metal layer forms a refractory metal silicide in the bottom of the contact opening.

2. The method of claim 1, wherein the step of etching the insulating layer comprises the steps of:

   forming a photoresist layer over the insulating layer;

   patterning and developing the photoresist layer;

   etching the insulating layer to form a contact opening and exposing a selected region of the conductive structure;

   removing the photoresist layer.

3. The method of claim 1 or 2, wherein the insulating layer is BPSG.

4. The method of claim 1 or 2, wherein the first refractory metal layer is titanium.

5. The method of claim 1 or 2, wherein the refractory metal nitride layer is titanium nitride.

6. The method of claim 1 or 2, further comprising the step of forming a second refractory metal layer over the refractory metal nitride layer and before the annealing step.

7. The method of claim 1 or 6, wherein a refractory metal layer, and the refractory metal nitride layer are formed through one path from a single chamber sputtering machine.

8. The method of claim 1 or 6, wherein a first refractory metal layer and the refractory metal nitride layer are formed through one path from a multi-chamber sputtering machine.

9. The method of claim 6, in which the second refractory metal layer is annealed in the annealing step.

10. The method of claim 9, wherein the first and second refractory metal layers and the refractory metal nitride layer are annealed in a nitrogen ambient.

11. A structure consisting of a portion of a semiconductor integrated circuit, comprising:
   a substrate;
   an insulating layer disposed over the substrate having an opening therethrough;
   a silicide layer in the bottom of the opening;
   a first titanium layer disposed over the insulating layer and in the opening; and,
   a refractory metal nitride layer disposed over the first titanium layer whereby the first titanium layer and the refractory metal nitride layer are annealed in a nitrogen ambient.

12. The structure of claim 11, further comprising a second titanium metal layer disposed over the refractory metal nitride layer whereby the first and the second titanium layers and the refractory metal nitride layer are annealed in a nitrogen ambient.

13. The method of claim 1 or 2, or the structure of claim 11, wherein the conductive structure is a source/drain region of a transistor.

14. The method or structure of claim 13, wherein the source/drain region is P+ type.

15. The method or structure of claim 13, wherein the source/drain region is N+ type.

FIG. 1

FIG. 2

European Patent
Office

**EUROPEAN SEARCH REPORT**

Application Number

EP    92 30 4216

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | PATENT ABSTRACTS OF JAPAN vol. 14, no. 550 (E-1009)6 December 1990 & JP-A-2 235 372 ( MITSUBISHI ELECTRIC CORP. ) 18 September 1990 * abstract * | 1,4-6, 9-12 | H01L21/285 |
| X | EP-A-0 209 654 ( K.K.TOSHIBA ) * column 3, line 10 - column 4, line 51 * * column 5, line 19 - line 26 * * figures 1A-1E * | 1,4-5,7, 11,13-15 | |
| A | US-A-4 926 237 (MOTOROLA INC.) * column 3, line 3 - line 39 * | 2-3 | |
| | | | TECHNICAL FIELDS SEARCHED (Int. Cl.5 ) |
| | | | H01L |

The present search report has been drawn up for all claims

| Place of search | Date of completion of the search | Examiner |
|---|---|---|
| THE HAGUE | 11 AUGUST 1992 | SCHUERMANS N. |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P0401)